# EUROPEAN PATENT APPLICATION

(11) **EP 4 391 007 A1**
(43) Date of publication of application: **26.06.2024**
(21) Application number: 23215745.3
(22) Date of filing: 12.12.2023
(51) Int. Cl.: H01J 37/14, H01J 37/22, H01J 37/26

(54) **POLE PIECE INCORPORATING OPTICAL CAVITY FOR IMPROVED PHASE-CONTRAST IN ELECTRON MICROSCOPE IMAGING**

(30) Priority: 20.12.2022 US 202218068769
(71) Applicant: FEI Company, Hillsboro, OR 97124-5793 (US)
(72) Inventor: BUIJSSE, Bart, Eindhoven (NL); DONA, Pleun, Velhoven (NL)
(74) Representative: Boult Wade Tennant LLP

(57) **Abstract**

Systems, methods, and components of charged particle microscopes affording improved contrast in dose sensitive samples are described. A pole piece for an electron microscope can include a body, being substantially concentric with a central axis. The body can define an upper surface, substantially normal to the central axis, a lower surface, substantially normal to the central axis, a central aperture formed in the body from the upper surface to the lower surface. The central aperture can be substantially rotationally symmetrical about the central axis. The body can define a lateral surface, inclined relative to the central axis and tapering toward the upper surface and a plurality of lateral apertures formed in the body from the lateral surface to the central aperture. The plurality of lateral apertures can be arrayed substantially symmetrically about the central axis.

## Description

### TECHNICAL FIELD

Embodiments of the present disclosure are directed to electron microscopy components, systems, and methods. In particular, some embodiments are directed toward components configured for improved contrast in electron microscope images.

### BACKGROUND

Electron microscopy of biological samples involves exposure of organic materials to a beam of electrons. Interaction between electrons and the sample generates different types of detectable signals that can be used for imaging and analysis. In transmission electron microscopes (TEMs), detailed information can be developed at the atomic scale, including images of the internal structures of biological materials, conformational information, and in-situ observations of microbiological processes.

TEM analysis of biological materials at progressively smaller length scales, such as those on the order of Angstroms to tens of Angstroms, introduces challenges in differentiating structures of interest from background signals or imaging artifacts. As such, there is a need to develop components, systems, and methods for improved contrast in electron microscope images, for example, in the field of cryogenic TEM analysis of biological materials.
Further aspects of the present disclosure as set forth in the following numbered clauses:-
Clause 1. A microscope system, comprising:
   a pole piece including a body, the body being substantially rotationally symmetrical about a central axis, wherein the body defines:
      an upper surface, substantially normal to the central axis;
      a lower surface, substantially normal to the central axis;
      a central aperture formed in the body from the upper surface to the lower surface, the central aperture being substantially rotationally symmetrical about the central axis;
      a lateral surface, inclined relative to the central axis and tapering toward the upper surface; and
      a plurality of lateral apertures formed in the body from the lateral surface to the central aperture, wherein the plurality of lateral apertures is arrayed substantially symmetrically about the central axis;
   an electron source configured to generate a beam of electrons substantially aligned with the central axis;
   a sample holder disposed in the microscope system at a first position on the central axis between the electron source and the pole piece; and
   one or more electromagnetic lenses configured to shape the beam of electrons such that the beam of electrons diverges away from the central axis at a second position on the central axis between the electron source and the sample holder.
Clause 2. The microscope system of clause 1, wherein the plurality of lateral apertures respectively intersect the central aperture at a vertical distance relative to the upper surface from about 5 mm to about 20 mm, corresponding to a first diffraction plane of the beam of electrons.
Clause 3. The microscope system of clause 1, wherein a lateral aperture of the plurality of lateral apertures tapers toward the central aperture at an angle from about 10 degrees to about 45 degrees relative to a lateral reference plane normal to the central axis.
Clause 4. The microscope system of clause 1, wherein:
   a lateral aperture of the plurality of lateral apertures defines a floor and a ceiling;
   a cross section of the lateral aperture parallel with the central axis defines a compound curve connecting the floor and the ceiling;
   the ceiling is characterized by a first radius of curvature from about 1 mm to about 10 mm; and
   the floor is characterized by a second radius of curvature from about 1 mm to about 10 mm.
Clause 5. The microscope system of clause 4, wherein the first radius of curvature is from about 1 mm to about 3 mm and wherein the second radius of curvature is from about 1 mm to about 5 mm.
Clause 6. The microscope system of clause 1, wherein the central aperture comprises a plurality of sections, wherein a first section of the plurality of sections is characterized by a diameter from about 1 mm to about 10 mm, wherein a second section of the plurality of sections is characterized by a diameter from about 5 mm to about 50 mm, and wherein the second section is wider than the first section.
Clause 7. The microscope system of clause 6, wherein a third section of the plurality of sections is characterized by a diameter from about 10 mm to about 30 mm, wherein the third section is wider than the second section, and wherein the second section is between the first section and the third section.

### BRIEF DESCRIPTION OF THE FIGURES

The foregoing aspects and many of the attendant advantages of the present disclosure will become more readily appreciated as the same become better understood by reference to the following detailed description, when taken in conjunction with the accompanying drawings.
FIG. 1A is a schematic diagram illustrating a transmission electron microscope (TEM) system, in accordance with some embodiments of the present disclosure.
FIG. 1B is a schematic diagram illustrating an objective section of a transmission electron microscope including components used for analysis of cryogenic samples, in accordance with some embodiments of the present disclosure.
FIG. 1C is a schematic diagram illustrating interaction of electromagnetic radiation with a beam of electrons, in accordance with some embodiments of the present disclosure.
FIG. 1D is a schematic diagram illustrating a sample under parallel illumination, in accordance with some embodiments of the present disclosure.
FIG. 1E is a schematic diagram illustrating a sample under divergent illumination, in accordance with some embodiments of the present disclosure.
FIG. 2A is a schematic diagram illustrating a cross section of a lower pole piece, in accordance with the current art.
FIG. 2B is a schematic diagram illustrating a cross section of a lower pole piece, in accordance with some embodiments of the present disclosure.
FIG. 2C is a schematic diagram illustrating a cross section of a lower pole piece including a graduated central aperture, in accordance with some embodiments of the present disclosure.
FIG. 3A is a schematic diagram illustrating a lower pole piece including lateral apertures, in accordance with some embodiments of the present disclosure.
FIG. 3B is a schematic diagram illustrating a lower pole piece including lateral apertures configured to optically couple electromagnetic radiation into the central aperture of the pole piece, in accordance with some embodiments of the present disclosure.
FIG. 3C is a schematic diagram illustrating a cross section of a lateral aperture, in accordance with some embodiments of the present disclosure.
FIG. 3D is a schematic diagram illustrating a lower pole piece including lateral apertures arranged substantially symmetrically about the central aperture, in accordance with some embodiments of the present disclosure.
FIG. 4 is a schematic diagram illustrating an optical cavity disposed in the central aperture of a lower pole piece including lateral apertures, in accordance with some embodiments of the present disclosure.
FIG. 5 is a block flow diagram illustrating an example process for improving phase contrast in electron microscope images, in accordance with some embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been illustrated and described, it will be appreciated that various changes can be made therein without departing from the spirit and scope of the disclosure.

In the forthcoming paragraphs, embodiments of an electron microscope system, components, and methods for improving contrast in electron microscope images are provided. Embodiments of the present disclosure include a transmission electron microscope incorporating a lower pole piece configured to receive, include, and/or incorporate an optical cavity or components of an optical cavity. The optical cavity can be configured to concentrate electromagnetic radiation onto a beam of electrons at a position substantially corresponding to a first diffraction plane of the beam of electrons. In some embodiments, the optical cavity can keep the area of the beam of electrons free of optical elements or other material. The lower pole piece can include a central aperture and multiple lateral apertures configured to accommodate the optical cavity and to permit EM radiation to be provided to the optical cavity from a radiation source external to the lower pole piece. As a result, imaging performance of TEM microscopes can be improved, for example, during imaging of biological samples.

Electron microscopy of biological samples involves exposure of biomaterials to a beam of electrons. Interaction between electrons and the sample generates different types of detectable signals that can be used for imaging and analysis. In transmission electron microscopes (TEMs), detailed information can be developed at the atomic scale, including images of the internal structures of biological materials, conformations of biomolecules, and in-situ observations of microbiological processes. TEM analysis of biological materials at progressively smaller length scales, such as those on the order of ones to tens of Angstroms, introduces challenges in differentiating structures of interest from background signals or imaging artifacts, due at least in part on the relatively low proportion of electrons that are scattered by biological samples. For at least these reasons, there is a need to develop components, systems, and methods for improved contrast in electron microscope images, for example, in the field of cryogenic TEM analysis of biological materials that exhibit sensitivity to radiation dose and a characteristic low signal-to-noise quality.

A similar technical challenge exists in the field of charged particle microscopy of microbiological samples. Typically, a biological sample (e.g., a protein particle, cell or cell fragment, viral particle, bacteria-derived materials, or the like) is prepared by freezing (e.g., liquid nitrogen temperatures) and subsequently being placed in a sample holder configured to maintain cryogenic conditions. Organic materials from which biological samples are typically composed scatter a relatively small fraction of incident electrons (e.g., as opposed to heavier elements like iron, gold, or the like). In consequence, background information is typically significant and limits contrast in TEM images of biological samples. Similarly, electron beam microanalysis that is routinely used in inorganic materials, such as crystal diffraction patterns (e.g., used to identify phase structures of semiconducting or metallic crystalline materials) is inhibited by relatively weak signal-to-background information. Approaches including, but not limited to, dark field TEM and Zernike Phase Contrast TEM modes can be used to reduce the relative proportion of background illumination and to increase the relative signal from scattered electrons in TEM images.

In the field of optical microscopy, resolved images of microbiological samples, which scatter a relatively small proportion of incident photons, can be improved through the use of phase-contrast microscopy. An operative principle of phase-contrast microscopy is to differentiate between photons that have been scattered by a sample and photons that have passed through the sample without scattering. In this context, scattering refers to an interaction between a photon and an atom of the sample that results in a phase shift of scattered photons. Introduction of optical elements (e.g., condenser annulus, phase shift ring, and filter ring elements) allows a phase-contrast microscope to selectively phase shift and attenuate unscattered photons and to improve contrast in images of biological samples. In contrast to photon optics, analogous optical elements are unavailable for charged particle optics systems, such as in TEM. For at least this reason, creating a controlled phase shift to either the scattered portion of an electron wave or an unscattered portion of the electron wave presents a significant technical challenge that impairs imaging of dose-sensitive samples.

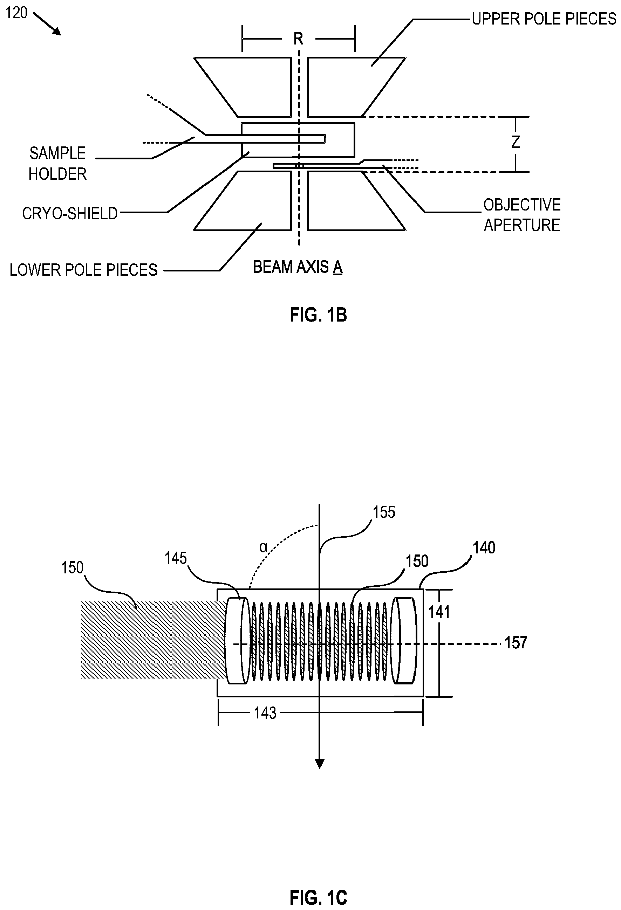

Electromagnetic radiation can be used to manipulate the beam of electrons generated in the TEM. As described in more detail in reference to FIG. 1C, stimulated Compton scattering can be induced in a beam of electrons by exposure to electromagnetic radiation (e.g., a continuous wave laser, a pulsed laser, x-rays, or the like). As a result of this exposure, the electron can undergo a phase shift. In an example embodiment, a continuous wave laser can be directed into a resonant optical cavity. This principle can be used to achieve phase-contrast TEM, but its application is limited, at least in part because the size of the optical cavity is constrained and because of the limited space available in proximity to the electron beam.

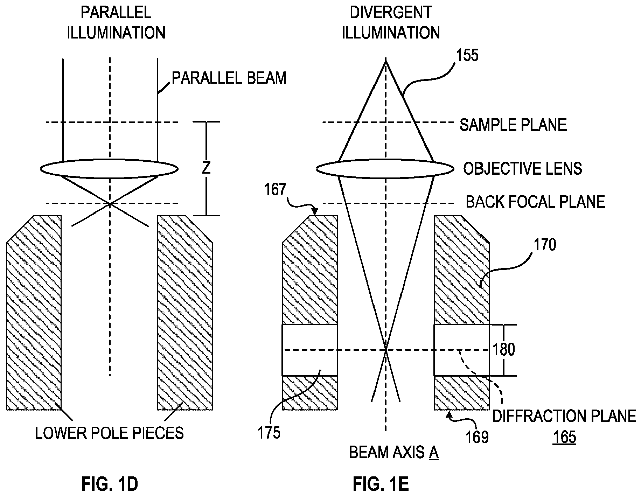

One approach to increase contrast of nanostructured materials composed principally of light elements is to defocus the beam of electrons prior to incidence with the sample and applying EM radiation to the beam of electrons of suitable intensity at a position of a diffraction plane, thereby stimulating Compton scattering. This mode of illumination is referred to in the forthcoming paragraphs as "divergent illumination," and described in reference to FIG. 1E. Such techniques permit, for example, visualization and measurement of interlayer spacings in carbon nanotubes and organic crystals that include a regular structure. Under divergent illumination, a first diffraction plane of the electron beam occurs at a point part-way between an upper surface and a lower surface of a lower pole piece forming a part of the objective section of the TEM, as described in more detail in reference to FIG. 1B, which allows a focal area of high intensity EM radiation to be aligned with the diffraction plane of the beam of electrons within a central aperture of the lower pole piece, away from other components of the objective section (e.g., the sample holder, an objective aperture, a cryobox, and a cryoshield).

Integration of an optical cavity into a body of the lower pole piece presents significant technical challenges. For example, apertures formed in the body to facilitate moving optical components into or out of the central aperture of the lower pole piece can lower the threshold maximum ampere-turns of the lens coil at which magnetic saturation of the pole piece material occurs. In another example, the shape, position, and orientation of the apertures is constrained by the position of the first diffraction plane and the angle of the optical cavity relative to a central axis of the lower pole piece. In yet another example, the size of the central aperture of the lower pole piece, which can be constrained by the inclusion of electromechanical alignment components, can introduce issues with maintaining vacuum integrity of the objective section and a liner tube of the TEM. In this way, configuring the lower pole piece to accept an optical cavity implicates multiple structural modifications to the lower pole piece that would not be used for other applications, such as vacuum system integration.

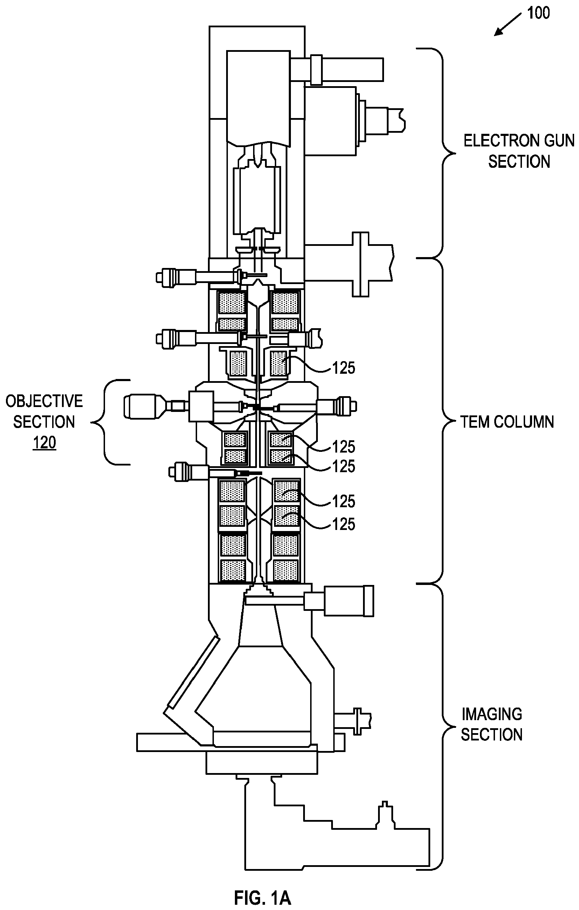

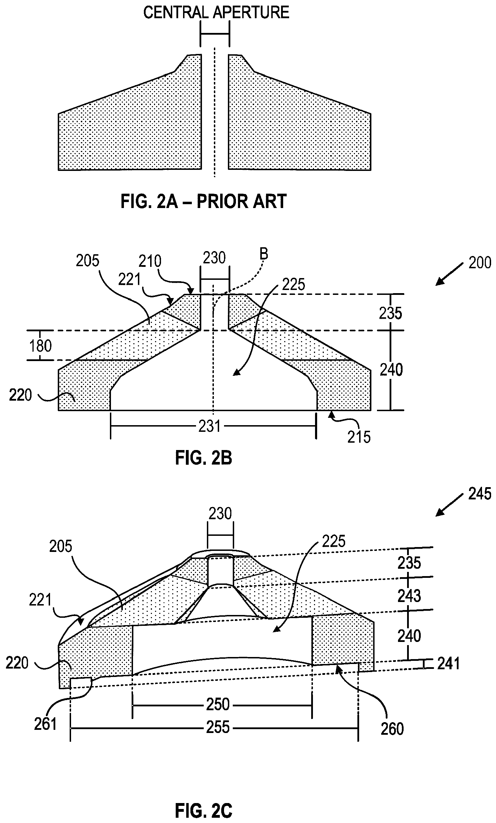

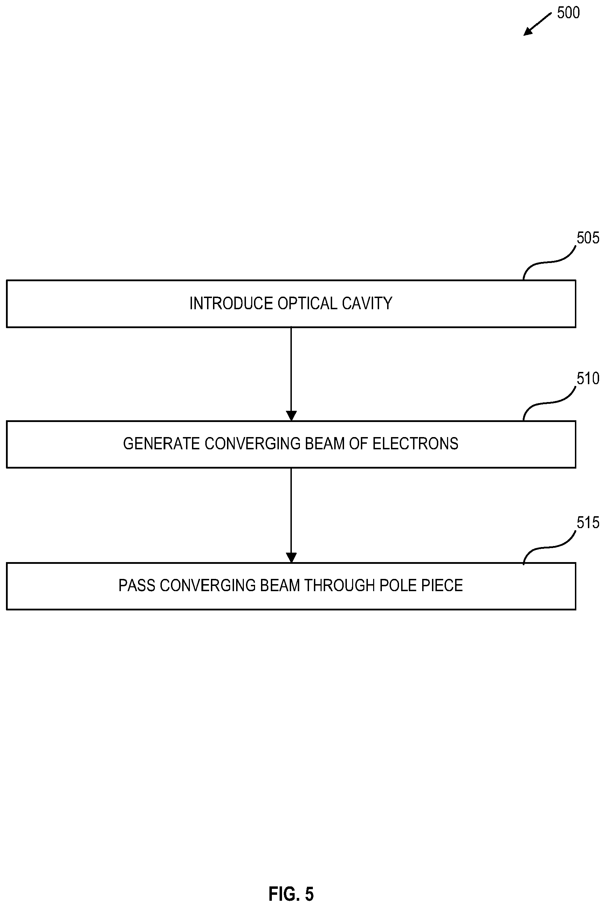

FIG. 1A is a schematic diagram illustrating an example transmission electron microscope (TEM) system 100, in accordance with some embodiments of the present disclosure. In the following description, details of internal components and functions of the example TEM system 100 are omitted for simplicity and to focus description on various components, as described in more detail in reference to FIGs. 1B-1E, configured as described in more detail in reference to FIGs. 2A-4 for augmenting contrast in TEM images, as described in more detail in reference to FIG. 5. The example TEM system 100 includes an electron gun section, a TEM column including an objective section 120, and an imaging section. The present disclosure focuses on the objective section 120. In brief, the electron gun section includes electronics configured to energize an electron source, which can include a high-voltage field-emission source or other sources of emitted electrons, such that a beam of electrons is formed and conducted through a vacuum into the TEM column.

The TEM column includes components for beam forming, including electromagnetic lenses 125 and multiple apertures to control properties of the beam of electrons. TEM column components include condenser lenses, objective lenses, projector lenses, among others, as well as corresponding apertures. The imaging section includes one or more types of detectors, sensors, screens, and/or optics configured to generate images, spectra, and other data for use in sample analysis. For example, the imaging section can include a scintillator screen, binoculars, scanning transmission electron microscopy (STEM) detector(s), camera(s), electron energy loss spectroscopy (EELS) detectors, among others.

FIG. 1B is a schematic diagram illustrating an example objective section 120 of a transmission electron microscope including components used for analysis of cryogenic samples, in accordance with some embodiments of the present disclosure. FIG. 1B omits some elements of the objective section illustrated in FIG. 1A, such as the vacuum enclosure, to focus description on components of the TEM 100 that interact with a beam of electrons. The example objective section 120 includes an upper pole piece, and a lower pole piece, a sample holder, and an objective aperture. In some cases, the objective section also includes components for use in imaging and/or analysis of cryogenic samples, such as a cryoshield. Similarly, the TEM 100 can be configured for automated serial analysis of multiple samples by including an automated sample loader.

In the context of the present disclosure, the volume available for integrating an optical cavity between the upper pole piece and the lower pole piece is limited by a lateral dimension "R" and a vertical dimension "Z," where "lateral" refers to a direction substantially normal to the beam axis, A, and "vertical" refers to a direction substantially parallel to the beam axis A. The term "substantially" is used to indicate that deviation in the angle between laterally oriented or vertically oriented components relative to the beam axis, A, can occur within the scope of the present disclosure.

For improved contrast, one possible approach is to introduce the optical cavity between the lower pole piece and the sample holder. Where optical components and/or retention apparatus are present between the lower pole piece and the sample holder, dimensions R and Z define the available volume between upper pole piece and lower pole piece for introduction of an optical cavity. The vertical dimension Z can be from about 3 mm to about 25 mm, with different vertical dimensions being used for different types of analysis. The lateral dimension R can be from about 10 mm to about 15 mm, although in some cases optical components and/or retention components can be disposed outside of the volume at the cost of increased complexity of the optical system. In some systems, the sample holder is substantially centered with respect to the vertical dimension Z. As such, the vertical space available for an optical cavity, between the sample holder and the lower pole piece, can be from about 2 mm to about 4 mm. Horizontal space reserved for the electron beam implicates a lateral distance of 1 mm - 5 mm in the R dimension to be kept free of optical components. For cryo-TEM applications, space constraints are greater, with space in the vertical dimension Z being limited to 1.5 mm or less (e.g., in some cases, no space is available). In this way, space limitations prevent the use of the optical cavity between the sample holder and the lower pole piece. Alternatively, the optical cavity can be introduced into the lower pole itself, as described in more detail in reference to FIGs. 1E - 4.

FIG. 1C is a schematic diagram illustrating an example optical cavity 140, in accordance with some embodiments of the present disclosure. In some embodiments, the example optical cavity 140 is configured to be integrated into a lower pole piece of an electron microscope, such as the TEM 100 of FIG. 1. In some embodiments, interaction of electromagnetic (EM) radiation 150 with a beam of electrons 155 is induced by passing the beam of electrons 155 through a focal area of EM radiation 150 that is recirculated in the optical cavity 140. To that end, the optical cavity 140 can include two or more mirrors 145 that together form a concentric-spherical cavity, a near-concentric cavity, a confocal cavity, a planar cavity, a near-planar cavity, or other configurations. The optical cavity 140 can be configured to concentrate EM radiation at the position of the beam of electrons 155 (e.g., at the position of the beam axis A). For example, constructive interference in the optical cavity 140 can be induced by aligning the mirrors 145 and setting a lateral distance 143 such that a focal area of EM radiation 150 intensity occurs substantially at the position of the beam of electrons 155. In an illustrative example, a 10 W laser can be introduced to the optical cavity 140, where it can be concentrated in a focal area about the beam axis A at a power of about 100 kW.

In some embodiments, the EM radiation 150 can include photons in the ultraviolet, visible, and/or infrared ranges. The EM radiation 150 can be provided to the optical cavity 140 as a beam of laser energy. For example, the EM radiation 150 can be a continuous wave laser, illustrated as a sinusoidal power signal. In an illustrative example, the EM radiation 150 can be generated in a Nd:YAG laser source or a CO₂ laser source, configured to emit photons at a wavelength of 1064 nm. In another example, the EM radiation 150 can include frequency-doubled photons at 532 nm.

As described in reference to FIG. 1B, maintaining space for the beam of electrons 155 to pass unimpeded through the optical cavity 140 can impose functional constraints on the structure, spacing, and orientation of the mirrors 145. The size 141 of the optical cavity 140 in the vertical Z dimension and the length 143 of the optical cavity 140 in the lateral R dimension includes the mirrors 145, the spacing between the mirrors 145, and the retention apparatus used to hold the mirrors 145 in place. In this way, the size of the optical cavity 140 can be compared to the space between the sample holder and the lower pole piece to determine whether the optical cavity 140 can be introduced external to the lower pole piece. Additionally, the cryo-box and the cryo-shield are also placed in the same area, further reducing the space available.

For a typical TEM system (e.g., TEM 100 of FIG. 1A) the distance between the sample holder and the lower pole piece can be from about 5 mm to about 11 mm, of which components of the sample stage, the objective aperture, and the components for cryo-microscopy can occupy as much as about 3 mm to about 4 mm below the sample plane. For the optical cavity 140 to be stable and to keep the area around the beam of electrons 155 free of optical components, the mirrors 145 can be from about 2 mm to about 10 mm in width (e.g., diameter). Including the retention apparatus can increase the vertical size of the optical cavity by as much as 10 mm or more. By comparing the size 141 to the available space, it can be seen that the optical cavity 140 is too large to be introduced between the sample holder and the lower pole piece.

Based at least in part on optical considerations, the optical cavity 140 can define an optical axis 157 that is oriented at an angle, α, relative to the beam of electrons 155, from about 45 degrees to about 90 degrees, including sub-ranges, fractions, and interpolations thereof. Orienting the optical cavity 140 at the angle α can reduce the modulation effect of the standing wave pattern on the phase shift. In this way, phase shift can be exhibit negligible or no sensitivity to the position along axis 157 where the electron transits the EM wave 150. In some embodiments, a standing wave lattice arising between mirrors 145 is characterized by a central axis that is not aligned with the optical axis 157. In some cases, α can be determined based at least in part on the angle between the beam axis A and the central axis of the lattice. In some embodiments, α can be an angle of about 45 degrees, about 50 degrees, about 55 degrees, about 60 degrees, about 65 degrees, about 70 degrees, about 75 degrees, about 80 degrees, about 85 degrees, or about 90 degrees, including fractions and interpolations thereof. Based at least in part on geometric considerations, performance of the optical cavity 140 can be impaired by an angle α above 50 degrees. To that end, above about 40 degrees, the length 143 of the optical cavity 140 used to maintain the area of the beam of electrons 155 clear of optical components can be impracticable, making the size 141 of the optical cavity 140 greater than the space available for the optical cavity 140 or at the cost of a smaller numerical aperture of the optical cavity 140. Additionally or alternatively, energy transfer into the optical cavity 140, for example, where EM radiation 150 is introduced into the optical cavity 140 via one or more of the mirrors 145, can be impaired at relatively high angles, at least in part due to challenges associated with coupling the EM radiation 150 (e.g., a laser beam) into the objective section at the appropriate point and angle.

Advantageously, introducing the optical cavity 140 into the path of the beam of electrons 155 can improve contrast in TEM images of biological samples or other samples that are sensitive to radiation dosage. Without being bound to a particular physical phenomenon or mechanism, the beam of electrons 155 can include a scattered portion and an un-scattered portion, where the scattered portion has collided with the sample (e.g., elastic interactions and/or inelastic interactions) and the un-scattered portion has transited the sample without colliding. Examples of interactions include absorption, reflection, deflection, ionization, or the like, that register as deviations from the background in TEM images. For example, in bright field TEM, a region of the sample that scattered electrons can appear darker than regions of the sample that did not scatter electrons. In this way, a sample that is characterized a generally low probability of scattering can include a relatively high proportion of un-scattered electrons and a relatively low proportion of scattered electrons, resulting in poor image contrast.

The interaction with the EM radiation 150 in the optical cavity 140 can result in a phase shift of the unscattered part of the electron wave 155 that is passing the EM radiation 150 (e.g., inducing a phase shift from about 0 rad to about π/2 rad), which can generate a phase-contrast enhancement of the electron microscope image.

FIG. 1D is a schematic diagram illustrating a sample under parallel illumination, in accordance with some embodiments of the present disclosure. In this context, parallel illumination refers to a technique of image generation in a TEM, such as the example TEM 100 of FIG. 1, where a substantially parallel beam of electrons passes through the sample plane. Regions of the sample that absorb, reflect, and/or scatter electrons usually appear dark in images and other regions appear bright and electromagnetic lenses shape the beam such that an image can be projected onto a detector surface in the imaging section of the TEM. In FIGs. 1D-1E, electromagnetic lenses are illustrated as solid optical lenses, but it is understood that electromagnetic lenses act on charged particles through the imposition of electromagnetic fields, rather than through refraction as in photon optics.

In parallel illumination, a back focal plane and a first diffraction plane coincide between the lower pole piece and the sample plane. To incorporate contrast enhancement using EM radiation described in reference to FIG. 1C, the optical cavity 140 can be positioned at the back focal plane. As described in more detail in reference to FIG. 1B, however, the space available for the optical cavity 140 is typically occupied by components of the sample holder or loader, an objective aperture, and/or a cryo-shield, among other elements of the objective section 120. To that end, constraints on the size of the optical cavity 140 make the introduction of optical components a significant structural challenge.

FIG. 1E is a schematic diagram illustrating a sample under divergent illumination, in accordance with some embodiments of the present disclosure. In some embodiments, the structural constraints are addressed by operating the TEM under divergent illumination. In this context, divergent illumination refers to a focusing of the beam of electrons 155 upstream of the sample plane such that the sample is illuminated by an expanding beam. As shown, the objective lens acts to concentrate the beam of electrons 155, with one or more of the central antinodes in a standing wave occurring on a diffraction plane 165 partway between an upper surface 167 and a lower surface 169 of a lower pole piece 170. In this way, one or more lateral apertures 175 can be formed in the lower pole piece 170 to accommodate the optical cavity 140. The position of the diffraction plane 165 can vary, based at least in part on the strength of the condenser lens or other operating parameters of the TEM 100. To that end, the diffraction plane 165 can form at a position on the beam axis A, relative to the sample plane, from about 10 mm to about 30 mm, including sub-ranges, fractions, and interpolations thereof. For example, the diffraction plane 165 can form at a position on the beam axis A, relative to the sample plane, of about 10 mm, about 11 mm, about 12 mm, about 13 mm, about 14 mm, about 15 mm, about 16 mm, about 17 mm, about 18 mm, about 19 mm, about 20 mm, about 21 mm, about 22 mm, about 23 mm, about 24 mm, about 25 mm, about 26 mm, about 27 mm, about 28 mm, about 29 mm, or about 30 mm, including fractions and interpolations thereof.

To facilitate insertion of the optical cavity 140 at the diffraction plane 165, a vertical dimension 180 of the lateral apertures 175 can overlap with the diffraction plane 165. As described in more detail in the forthcoming paragraphs, aspects of the lower pole piece 170 are structured to introduce the optical cavity 140 such that a central antinode of the optical cavity 140 substantially coincides with the diffraction plane 165 of the beam of electrons 155 under divergent illumination. In some cases, operating under divergent illumination can affect some aspects of optical performance. That being said, the effects, such as non-isotropic magnification, image distortion, and off-axis coma can be addressed with software correction of images or they can be ignored if they do not impact the image quality.

FIG. 2A is a schematic diagram illustrating a cross section of a lower pole piece, in accordance with the current art. In TEM systems of the current art, the lower pole piece does not typically include lateral apertures 175 as described in reference to FIG. 1E. Instead, lower pole piece of the current art typically include solid bodies that are rotationally symmetrical about a central aperture, aligned with the beam axis A of the TEM. In some TEM systems, lower pole piece of the current art incorporate additional apertures to serve as conduits of a vacuum system (as in environmental TEM systems) or to facilitate introduction of a beam aperture component, similar to the objective aperture, that is referred to as a "high contrast aperture." In the context of vacuum conduits, couplings with vacuum components and orientation and/or location of the additional apertures do not facilitate the introduction of the optical cavity 140 at the diffraction plane 165. For example, the additional apertures are mechanically and fluidically coupled with vacuum systems, precluding the introduction of the optical cavity 140. Similarly, while the high contrast aperture can be used to enhance contrast in images of biological samples, the high contrast aperture is not inserted in a diffraction plane.

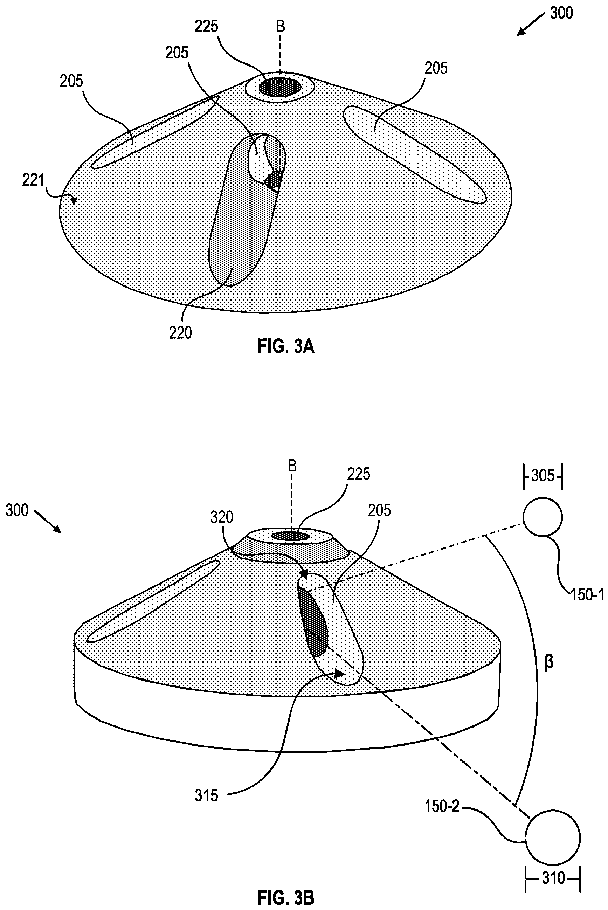

FIG. 2B is a schematic diagram illustrating a cross section of an example lower pole piece 200, in accordance with some embodiments of the present disclosure. Example lower pole piece 200 is an example of lower pole piece 170 of FIG. 1E, which can be incorporated in example TEM system 100 of FIG. 1A. Example lower pole piece 200 includes multiple lateral apertures 205, disposed between an upper surface 210 and a lower surface 215 of a body 220. The example lower pole piece 200 further includes a central aperture 225, concentric with a central axis, B, about which the lateral apertures 205 are substantially symmetrically arrayed (e.g., rotationally symmetrical), as described in more detail in reference to FIGs. 3A-3D. As illustrated in FIG. 2B, the lateral apertures 205 are formed in the body 220 from a lateral surface 221 of the body 220 to the central aperture 225. The lateral surface 221 is inclined relative to the central axis B and tapers toward the upper surface 210.

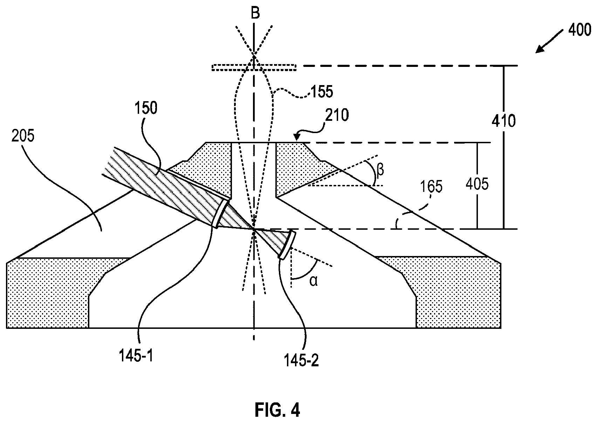

In this way, the lateral apertures 205 can be characterized by the vertical dimension 180. As illustrated in FIG. 2B, the vertical dimension 180 can vary with radial distance from the central axis B. For example, the vertical dimension 180 is illustrated increasing with increasing distance from the central axis B. In some embodiments, the vertical dimension 180 is substantially independent of radial distance from the central axis B. To facilitate optical coupling of EM radiation 150 into the central aperture 225 at the position of the diffraction plane 175 the vertical dimension 180 of the lateral aperture(s) 205 at the intersection with the central aperture 225 can overlap a range of positions of the diffraction plane 175, as described in more detail in reference to FIG. 3B, and FIG. 4.

In some embodiments, the central aperture 225 is structured to integrate one or more components of the optical cavity 140 by including multiple sections, over which the central aperture 225 expands from a first width 230 at the upper surface 210 to a second width 231 at a position downstream of the upper surface 210 (e.g., at the lower surface 215). In the example lower pole piece 200 illustrated in FIG. 2B, the central aperture 215 defines a first section 235 and a second section 240, with the central aperture 215 having a width substantially equal to the first width 230 in the first section 235 and an axially varying width, increasing from the first width 230 to the second width 231 at the lower surface 215. In this way, the central aperture 215 tapers toward the upper surface 210. The second width 231 can be from about 3 mm to about 50 mm, including sub-ranges, fractions, and interpolations thereof. For example, the second width 231 can be about 3 mm, about 5 mm, about 10 mm, about 15 mm, about 20 mm, about 25 mm, about 30 mm, about 35 mm, about 40 mm, about 45 mm, or about 50 mm, including fractions and interpolations thereof. The second width 231 can be determined based at least in part on the magnetic saturation behavior of the lower pole piece 200 and the space used to house optical components and to keep the area around the beam of electrons 155 clear.

In some embodiments, the central aperture 215 is substantially symmetrical about the central axis B. The body 220 can be formed of a material that conducts magnetic fields (e.g., characterized by relatively high magnetic permeability), as an approach to using electromagnetic lenses in the objective section 120 of the TEM 100.

FIG. 2C is a schematic diagram illustrating a cross section of an example lower pole piece 245 including a graduated central aperture 225, in accordance with some embodiments of the present disclosure. Example lower pole piece 245 includes four sections: the first section 235, the second section 240, a third section 241, and a fourth section 243. With increasing distance from the upper surface 210 toward the lower surface 215, the width of each progressive section increases, from the first width 230 to a second width 250 and then to a third width 255. It is noted that the geometries illustrated in FIG. 2C are not executed to scale and are provided to illustrate structural features of the central aperture 225. To that end, the third section 241 can define an intermediate surface 260, between the upper surface 210 and the lower surface 215 with respect to the central axis B. In some embodiments, the intermediate surface 260 can include a groove, ridge, knife edge, or other surface feature 261 configured to form a vacuum tight seal with a corresponding component of the TEM system 100, such as a liner tube, flange adapter, or the like, for example, via a metal gasket or elastomeric o-ring. The flange adapter can be configured to interface at a first surface with the intermediate surface 260 and with the liner tube on a second surface. To that end, the example lower pole piece 245 can be configured to mechanically couple with the liner tube via the flange adapter.

In some embodiments, the second width 250 of the second section 240 can be substantially constant and can be wider than the first width 230 and narrower than the third width 255. The third width 255 can be from about 5 mm to about 100 mm, including sub-ranges, fractions, and interpolations thereof. For example, the second width 231 can be about 5 mm, about 10 mm, about 15 mm, about 20 mm, about 25 mm, about 30 mm, about 35 mm, about 40 mm, about 45 mm, or about 50 mm, about 55 mm, or about 60 mm, about 65 mm, or about 70 mm, about 75 mm, about 80 mm, about 85 mm, about 90 mm, about 95 mm, about 100 mm, including fractions and interpolations thereof. The third width 255 can be determined based at least in part on structural constraints involved in forming a vacuum tight seal without deforming the lower pole piece 245, with larger widths being limited by the vertical space available in the objective section 120. For example, to reduce strain-deformation of the lower pole piece 245, a larger third width 255 can correspond to a larger third section 241, which can also influence the electromagnetic characteristics of the objective section 120 (e.g., objective lens performance).

In some embodiments, the fourth section 243 can taper toward the first section 235, having a width at the junction of the fourth section 243 and the second section 240 that can be less than or equal to the second width 250. In this way, the pole pieces 200 and 245 of FIGs. 2B-2C can be configured to include lateral apertures 205 that facilitate the introduction of the optical cavity 140 and the EM radiation 150 into the central aperture 225. Further, the central aperture can incorporate components of the optical system used to align and/or operate the optical cavity 140 that occupy additional space and can remain in the lower pole piece 200 and 245 while the optical cavity 140 is absent. In this way, the size 141 and length 143 of the optical cavity 140 can be reduced relative to a system that incorporates alignment and calibration components in a retractable member that is extended into the central aperture 225 through a lateral aperture 205.

FIG. 3A is a schematic diagram illustrating an example lower pole piece 300 including multiple lateral apertures 205, in accordance with some embodiments of the present disclosure. The example lower pole piece 300 is illustrated in partial section to focus description on the lateral surface 221 and the lateral apertures 205 formed through the body 220 from the lateral surface 221 to the central aperture 225. In this way, example lower pole piece 300 is an example of the lower pole piece 170 of FIG. 1E and the lower pole pieces 200 and 245 of FIGs. 2B-2C. In the illustrated embodiment of example lower pole piece 300, four lateral apertures 205 are formed in the lateral surface 221 that are substantially symmetrical about the central axis B. In the context of the present disclosure, a substantially symmetrical arrangement of the lateral apertures 205 about the central axis B is a functional consideration at least in part because the lateral apertures 205 are characterized by a different field permittivity than the body 220. In this way, an asymmetric arrangement can interfere with the operation of electromagnetic lenses used to form the beam of electrons 155, thereby introducing aberration, imaging artifacts, or decreased resolution in TEM imaging and microanalysis. Conversely, rotational symmetry can induce aberrations, making the size, shape, and orientation of lateral apertures 205 functionally constrained by performance considerations.

FIG. 3B is a schematic diagram illustrating the example lower pole piece 300 including lateral apertures 205 configured to optically couple electromagnetic radiation into the central aperture 225 of the pole piece 300, in accordance with some embodiments of the present disclosure. The example lower pole piece 300 can include lateral apertures 205 that are structured to optically couple one or more modalities of EM radiation (e.g., EM radiation 150 of FIG. 1E) into the central aperture 225. In the illustrated embodiment of FIG. 3B, the lateral aperture 205 is structured to couple first EM radiation 150-1 into and/or out of the central aperture 225 at one position of the lateral aperture 205 and is also structured to couple second EM radiation 150-2 into and/or out of the central aperture 225 at a second position of the lateral aperture 205. The first EM radiation 150-1 is characterized by a first diameter 305 and the second EM radiation 150-2 is characterized by a second diameter 310. In some embodiments, the second diameter 310 is equal to or wider than the first diameter 305. In this context, the term "diameter" is used to describe a beam having a "width" attributed to a position at which power, flux, or the like, is below a threshold value (e.g., Rayleigh beamwidth, full width at half maximum, etc.). In some embodiments, first EM radiation 150-1 and second EM radiation 150-2 have substantially equal energy properties (e.g., central wavelength, energy distribution function, etc.). For example, the optical cavity 140 can include a single-wavelength horizontal cavity in-coupled via second diameter 310, a single-wavelength tilted cavity in-coupled via first diameter 305, a single-wavelength multiple-mirror optical cavity 140 coupling EM radiation via first diameter 305 and second diameter 310.

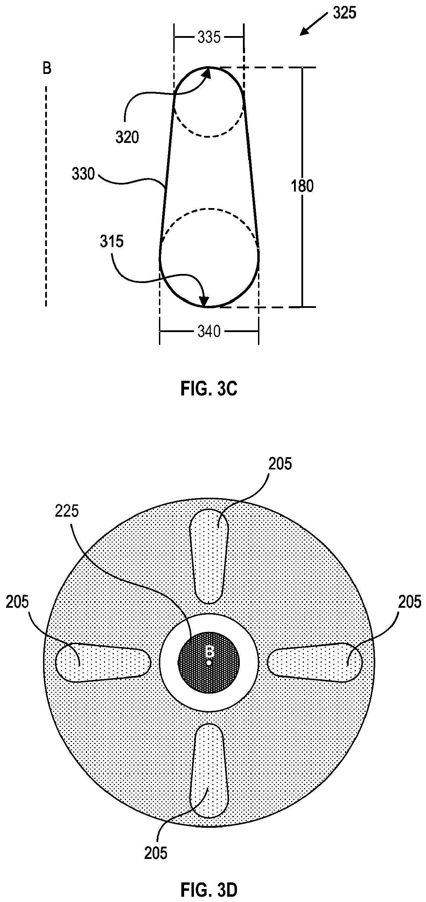

As described in more detail in reference to FIG. 4B, the lateral aperture 205 can taper toward the central aperture 225. In some embodiments, the lateral aperture(s) 205 define a floor 315 and a ceiling 320, corresponding to regions of an inner surface of the lateral aperture(s) 205 that are proximal to the lower surface 215 and the upper surface 210, respectively. As described in more detail in reference to FIG. 3C, the floor 315 and/or the ceiling 320 can be or include curved surfaces. In this way, a line of the ceiling 320 nearest the upper surface 210 and a line of the floor 315 nearest the lower surface 215 can define an angle geometrically similar to angle β or an angle greater than angle β. In some embodiments, the floor 315 is substantially normal to the central axis B, while the ceiling 320 slopes toward the central aperture 225. In some embodiments, both the ceiling 320 and the floor 315 taper toward the central aperture 225.

FIG. 3C is a schematic diagram illustrating a cross section 325 of an example lateral aperture 205, in accordance with some embodiments of the present disclosure. In some embodiments, the cross-section 325 defines a periphery 330 of the lateral aperture 205 that assumes a shape of a compound curve, where the floor 315 and the ceiling 320 are substantially circular segments that are joined by substantially straight segments. In this way, the lateral aperture 205 can include a region of empty space within the body 220 bridging two substantially cylindrical regions of empty space. In some embodiments, the ceiling 320 corresponds to a portion of a substantially circular periphery with a first diameter 335. As such, the ceiling 320 can be characterized by a first radius of curvature (e.g., half of the first diameter 335) from about 1 mm to about 10 mm, including sub-ranges, fractions, and interpolations thereof. For example, the first radius of curvature can be about 1 mm, about 2 mm, about 3 mm, about 4 mm, about 5 mm, about 6 mm, about 7 mm, about 8 mm, about 9 mm, about 10 mm, or greater, including fractions or interpolations thereof. In some embodiments, the first radius of curvature is substantially equal to the first diameter 305 or larger than the first diameter 305. As such, the lateral aperture(s) 205 can be structured to couple first EM radiation 150-1 into and/or out of the central aperture 225 (e.g., via the optical cavity 140) while reducing the proportion of first EM radiation 150-1 that is absorbed or reflected by the body 220. As an example of a sub-range, the second radius of curvature can be from about 1 mm to about 3 mm in some embodiments, corresponding to a first diameter 335 from about 2 mm to about 6 mm.

In some embodiments, the floor 315 corresponds to a portion of a substantially circular periphery with a second diameter 340. As such, the floor 315 can be characterized by a second radius of curvature (e.g., half of the second diameter 340) from about 1 mm to about 10 mm, including sub-ranges, fractions, and interpolations thereof. As with the first radius of curvature, the second radius of curvature can be about 1 mm, about 2 mm, about 3 mm, about 4 mm, about 5 mm, about 6 mm, about 7 mm, about 8 mm, about 9 mm, about 10 mm, or greater, including fractions or interpolations thereof. In some embodiments, the second radius of curvature is substantially equal to the second diameter 310 or larger than the second diameter 310. As such, the lateral aperture(s) 205 can be structured to couple second EM radiation 150-2 into and/or out of the central aperture 225 (e.g., via the optical cavity 140 or via additional mirrors 145 as described in reference to FIG. 4B) while reducing the proportion of second EM radiation 150-2 that is absorbed or reflected by the body 220. As an example of a sub-range, the second radius of curvature can be from about 1 mm to about 5 mm in some embodiments, corresponding to a second diameter 340 from about 2 mm to about 10 mm.

The vertical dimension 180 can be from about 5 mm to about 20 mm, including fractions, sub-ranges, and interpolations thereof. As described in more detail in reference to FIG. 1E, the lateral aperture(s) 205 are structured to accommodate the optical cavity 140 being introduced into the central aperture as part of the techniques described in reference to FIG. 1D. To that end, the lateral apertures(s) 205 can taper toward the central aperture 225, with the vertical dimension 180 increasing with increasing distance from the central aperture 225. In some embodiments, the vertical dimension 180 at the intersection with the central aperture 225 is from about 5 mm, about 6 mm, about 7 mm, about 8 mm, about 9 mm, about 10 mm, about 11 mm, about 12 mm, about 13 mm, about 14 mm, about 15 mm, about 16 mm, about 17 mm, about 18 mm, about 19 mm, about 20 mm, or larger, including fractions and interpolations thereof.

FIG. 3D is a schematic diagram illustrating the example lower pole piece 300 including lateral apertures 205 arranged substantially symmetrically about the central aperture 225, in accordance with some embodiments of the present disclosure. In some embodiments, the example lower pole piece 300 includes two, three, four, five, six, or more apertures, arranged in a rotationally symmetric pattern about central axis B. For example, an arrangement of four lateral apertures 205 can be characterized by a relative angle of 90 degrees between neighboring lateral apertures 205, and a relative angle of 180 degrees between opposing lateral apertures 205. Similarly, for three lateral apertures, neighboring lateral apertures 205 can be separated by a relative angle of 120 degrees, for five lateral apertures 205, a relative aperture of 72 degrees. In this way, the neighboring lateral apertures 205 can be determined from the ratio of 360 degrees and the number of lateral apertures 205. As with the symmetry of the arrangement of the lateral apertures 205, the number of lateral apertures 205 is a functional consideration, based at least in part on the impact of the lateral apertures on performance of electromagnetic lenses in the objective section of the TEM 100. For example, using three lateral apertures 205 can reduce saturation of the electromagnetic field in the vicinity of the example lower pole piece 300, but can also introduce geometric considerations, such as providing for access to the central aperture from opposing sides, for example, to be used to outcouple EM radiation from the pole piece.

FIG. 4 is a schematic diagram illustrating an optical cavity 140 disposed in the central aperture 225 of a lower pole piece 400 including lateral apertures 205, in accordance with some embodiments of the present disclosure. In the diagram, components of the optical cavity 140, such as a retention apparatus, alignment actuators, control electronics, or the like, are omitted to focus description on structural aspects of the lower pole piece 400. For example, lateral apertures 205 are formed in the lower pole piece 400 to accommodate the alignment of the optical cavity 140 with the diffraction plane 165 formed by the beam of electrons 155 when operating under divergent illumination. To that end, the lateral aperture(s) can overlap a position on the central axis B corresponding to a vertical distance 405 from the upper surface 210 to the diffraction plane 165, from about 5 mm to about 20 mm, including sub-ranges, fractions, and interpolations thereof. In some embodiments, the vertical distance 405 is about 5 mm, about 6 mm, about 7 mm, about 8 mm, about 9 mm, about 10 mm, about 11 mm, about 12 mm, about 13 mm, about 14 mm, about 15 mm, about 16 mm, about 17 mm, about 18 mm, about 19 mm, or about 20 mm, including fractions and interpolations thereof. A second vertical distance 410 describes the separation between the sample plane and the diffraction plane 165 under divergent illumination, as described in reference to FIG. 1E (e.g., from about 10 mm to about 30 mm). As such, the difference between the second distance 410 and the distance 405 can correspond to one half of the vertical spacing Z, as described in more detail in reference to FIG. 1B.

EM radiation 150, such as a beam of photons, can be coupled into the optical cavity 140 via one or more mirrors 145. In the illustrated embodiment, EM radiation 150, corresponding to first EM radiation 150-1 of FIG. 3B, is coupled into a first mirror 145-1 that is configured to transmit the EM radiation 150 in a forward direction and to reflect the EM radiation 150 in the reverse direction. In this way, EM radiation 150 coupled into the optical cavity is trapped in the optical cavity 140, notwithstanding various loss mechanisms attributable to material and physical properties of the mirrors 145 and mirror substrates. The optical cavity 140 can include a second mirror 145-2 that generate the optical conditions at the diffraction plane 165 that result in a phase shift of the electron beam (e.g., phase-shifted beam 162 of FIG. 1D). To that end, the optical cavity 140 can include two or more mirrors 145. In another example, each mirror can have a respective radius of curvature that shapes the EM radiation 150 as an approach to reducing the size 141 and length 143 of the optical cavity. The diameter of the beam of EM radiation 150 at the second mirror 145-2 can be narrower, wider, or equal to the diameter of the beam of EM radiation 150 coupled into the first mirror 145-1.

As described in more detail in reference to FIG. 1C, the first mirror 145-1 and the second mirror 145-2 can be oriented relative to the central axis B by an angle α. As described in more detail in reference to FIG. 1C, the angle α can be determined based at least in part on the angle that gives rise to a lattice fringe pattern that is oriented relative to the beam axis A by a given angle. In some embodiments, for example, where mirrors are configured to generate the lattice fringe pattern that is substantially centered between the mirrors and aligned substantially normal to the optical axis 157, the angular alignment of the lattice fringes and the angle α can be equal.

To facilitate coupling EM radiation 150 into the first mirror 145-1, or to accommodate the first mirror 145-1 and/or the other elements of the optical cavity 140 into the central aperture 225, the lateral aperture(s) 205 can taper toward the central aperture 225 at an angle, relative to a plane normal to the central axis B, substantially equal to or greater than the angle β. In some embodiments, the taper angle is less than the angle β, for example, where the vertical dimension 180 of the lateral aperture(s) 205 is large enough to accommodate the optical cavity 140 and incident EM radiation 150 without interference by the body 220. It is understood however, that constraints are imposed on the structure of the lateral apertures 205 by the threshold for magnetic saturation of the pole piece.

FIG. 5 is a block flow diagram illustrating an example process 500 for improving phase contrast in electron microscope images, in accordance with some embodiments of the present disclosure. One or more operations of the example process 500 may be executed by a computer system in communication with additional systems including, but not limited to, characterization systems, network infrastructure, databases, and user interface devices. In some embodiments, at least a subset of the operations described in reference to FIG. 5 are performed automatically (e.g., without human involvement) or semi-automatically (e.g., with human initiation or limited human intervention). In an illustrative example, operations for generating and shaping the beam of electrons 155 can be executed automatically, with the TEM system 100 being configured to maintain properties of the beam of electrons 155 at or about a set point that can be designated by a human user. In another illustrative example, a human user can initiate phase-contrast imaging using the techniques described herein by activating a subsystem of the TEM 100 (e.g., through an interactive user environment presented through a user terminal, such as a browser or software application, and/or a push-button control panel) that automatically modifies the operation of the TEM 100 from parallel illumination mode to divergent illumination mode and automatically extends the optical cavity 140 into the central aperture 225 or bring the cavity that is already present in suitable operation conditions. To that end, while example process 500 is described as a sequence of operations, it is understood that at least some of the operations can be omitted, repeated, and/or reordered. In some embodiments, additional operations precede and/or follow the operations of example process 500 that are omitted for clarity of explanation. For example, operations for calibration of the electron source, alignment and aberration correction of the beam of electrons 155, or the like.

In some embodiments, example process 500 includes introducing the optical cavity 140 into the central aperture 225 at operation 505, as described in more detail in reference to FIGs. 4A-4B. Introducing the optical cavity 140 can include one or more sub-processes, such as actuating an arm bearing the optical cavity 140, retention structure, alignment mechanisms, or the like, to move the optical cavity 140 into position in the central aperture 225. The position of the optical cavity 140 in the central aperture 225 corresponds to a vertical position on the central axis B of the diffraction plane 165, as described in more detail in reference to FIG. 1E. The retention structure, alignment mechanisms, or other components of the TEM system 100 can retain a pair of mirrors in a configuration that is aligned along an optical axis 157 angled relative to the central axis 225 by the angle α.

Example process 500 can omit operation 505. For example, the optical cavity 140 can be configured to maintain a clearance about the beam axis A, as where one or more components of the optical cavity 140 are disposed in the central aperture 225. In an illustrative example, mirrors 145 and/or a retention apparatus can be disposed in the central aperture 225, such that the optical cavity 140 can remain in the central aperture 225 over multiple iterations of example process 500, during operation of the TEM 100 in general, etc. In some embodiments, the optical cavity 140 can already be present in the central aperture 225 prior to initiation of the example process 500.

In some embodiments, example process 500 includes generating a converging beam of electrons 155 at operation 510. The operation 510 can follow other operations for generating a diverging beam upstream of the sample plane, such that the sample is exposed under divergent illumination. In this way, force applied to the beam of electrons 155 to converge toward the diffraction plane can be applied downstream of the sample plane. As described in more detail in reference to FIG. 1E, the converging beam of electrons 155 is aligned with the beam axis A and converges toward the diffraction plane 165. The diffraction plane 165 intersects the central axis 225 at a position on the central axis 225 between the upper surface 210 and the lower surface 215 and is aligned with the plurality of lateral apertures 205. Generating the converging beam of electrons 155 can include applying an electromagnetic force to the beam of electrons 155 using one or more electromagnetic lenses 125 (e.g., condenser lens(es)) in the TEM column, resulting in shifting one of the central antinodes (or fringes) to a position in the central aperture 225 of a lower pole piece (e.g., example lower pole piece 200 of FIG. 2B, example lower pole piece 245 of FIG. 2C, example lower pole piece 300 of FIGs. 3A-3B, example lower pole piece 400 of FIG. 4A, or example lower pole piece 450 of FIG. 4B) in accordance with the converging beam of electrons being passed through the pole piece at operation 515.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on electron microscopy systems, and TEM systems in particular, these are meant as non-limiting, illustrative embodiments. Embodiments of the present disclosure are not limited to such materials, but rather are intended to address charged particle beam systems for which a wide array of particles can be applied to imaging, microanalysis, and/or processing of materials on an atomic scale. Such particles may include, but are not limited to, electrons or ions in TEM systems, SEM systems, STEM systems, ion beam systems, and/or particle accelerator systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property or numerical value within which the deviation has little to no influence of the corresponding function, property, or attribute of the structure being described. In an illustrated example, where a dimensional parameter is described as "substantially equal" to another dimensional parameter, the term "substantially" is intended to reflect that the two dimensions being compared can be unequal within a tolerable limit, such as a fabrication tolerance. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. In an example, the central axis B of the lower pole piece 200 can be "substantially aligned" with the beam of electrons 155, which can include a deviation from exact alignment resulting from physical phenomena affecting the direction of the beam of electrons 155 (e.g., beam drift). For dimensional values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims.

Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A pole piece for an electron microscope, the pole piece comprising:
a body, being substantially concentric with a central axis, wherein the body defines:
an upper surface, substantially normal to the central axis;
a lower surface, substantially normal to the central axis;
a central aperture formed in the body from the upper surface to the lower surface, the central aperture being substantially rotationally symmetrical about the central axis;
a lateral surface, inclined relative to the central axis and tapering toward the upper surface; and
a plurality of lateral apertures formed in the body from the lateral surface to the central aperture,
wherein the plurality of lateral apertures is arrayed substantially symmetrically about the central axis.

2. The pole piece of claim 1, wherein the plurality of lateral apertures respectively intersect the central aperture at a vertical distance relative to the upper surface from about 5 mm to about 20 mm.

3. The pole piece of claim 1 or claim 2, wherein a lateral aperture of the plurality of lateral apertures is **characterized by** a vertical dimension, aligned with the central axis, from about 5 mm to about 15 mm.

4. The pole piece of claim 1, claim 2 or claim 3, wherein a lateral aperture of the plurality of lateral apertures tapers toward the central aperture at an angle from about 10 degrees to about 45 degrees relative to a lateral reference plane normal to the central axis.

5. The pole piece of any preceding claim, wherein:
a lateral aperture of the plurality of lateral apertures defines a floor and a ceiling;
a cross section of the lateral aperture parallel with the central axis defines a compound curve connecting the floor and the ceiling;
the ceiling is **characterized by** a first radius of curvature from about 1 mm to about 10 mm; and
the floor is **characterized by** a second radius of curvature from about 1 mm to about 10 mm.

6. The pole piece of claim 5, wherein the first radius of curvature is from about 1 mm to about 3 mm and wherein the second radius of curvature is from about 1 mm to about 5 mm.

7. The pole piece of any preceding claim, wherein the central aperture comprises a plurality of sections, wherein a first section of the plurality of sections is **characterized by** a diameter from about 1 mm to about 10 mm, wherein a second section of the plurality of sections is **characterized by** a diameter from about 5 mm to about 50 mm, and wherein the second section is wider than the first section.

8. The pole piece of claim 7, wherein a third section of the plurality of sections is **characterized by** a diameter from about 10 mm to about 30 mm, wherein the third section is wider than the second section, and wherein the second section is between the first section and the third section.

9. A microscope system, comprising:
the pole piece of any one of the preceding claims;
an electron source configured to generate a beam of electrons substantially aligned with the central axis of the pole piece;
a sample holder disposed in the microscope system at a first position on the central axis of the pole piece, between the electron source and the pole piece; and
one or more electromagnetic lenses configured to shape the beam of electrons such that the beam of electrons diverges away from the central axis at a second position on the central axis between the electron source and the sample holder.

10. The microscope system of claim 9, wherein the plurality of lateral apertures respectively intersect the central aperture at a vertical position on the central axis corresponding to a first diffraction plane of the beam of electrons.

11. A method of phase-contrast imaging using an electron microscope, the method comprising:
generating a converging beam of electrons, such that the beam of electrons is aligned with a beam axis and converges toward a diffraction plane on the beam axis; and
passing the converging beam through a pole piece, the pole piece comprising:
an electrically conductive body, the body being substantially rotationally symmetrical about a central axis, the central axis being substantially aligned with the beam axis, wherein the body defines:
an upper surface, substantially normal to the central axis;
a lower surface, substantially normal to the central axis;
a central aperture formed in the body from the upper surface to the lower surface, the central aperture being substantially rotationally symmetrical about the central axis;
a lateral surface, inclined relative to the central axis and tapering toward the upper surface; and
a plurality of lateral apertures formed in the body from the lateral surface to the central aperture, wherein the plurality of lateral apertures is arrayed substantially symmetrically about the central axis,
wherein the diffraction plane is at a position on the central axis between the upper surface and the lower surface and is aligned with the plurality of lateral apertures.

12. The method of claim 11, wherein:
the converging beam converges to the diffraction plane at a first vertical distance from the sample from about 10 mm to about 25 mm;
the lateral apertures of the plurality of lateral apertures respectively intersect the central aperture at a second vertical distance relative to the upper surface from about 5 mm to about 15 mm; and
the first vertical distance and the second vertical distance coincide.

13. The method of claim 11 or claim 12, wherein:
a lateral aperture of the plurality of lateral apertures defines a floor and a ceiling;
a cross section of the lateral aperture parallel with the central axis defines a compound curve connecting the floor and the ceiling;
the ceiling is **characterized by** a first radius of curvature from about 1 mm to about 10 mm; and
the floor is **characterized by** a second radius of curvature from about 1 mm to about 10 mm, the second radius of curvature being larger than the first radius of curvature.

14. The method of claim 11, claim 12 or claim 13, wherein a lateral aperture of the plurality of lateral apertures tapers toward the central aperture at an angle from about 10 degrees to about 45 degrees relative to a lateral reference plane normal to the central axis.

15. The method of any one of claims 11-14, further comprising:
introducing an optical cavity into the central aperture, the optical cavity being formed by two or more mirrors, wherein a pair of the mirrors are aligned along an optical axis angled relative to the central axis by an angle, α, from about 45 degrees to about 90 degrees.
